# EUROPEAN PATENT SPECIFICATION

(11) **EP 1 005 123 B1**
(45) Date of publication and mention of the grant of the patent: **02.03.2005**
(21) Application number: 99123020.2
(22) Date of filing: 19.11.1999
(51) Int. Cl.: H01S 5/323, H01S 5/22, H01L 33/00

(54) **Semiconductor laser, semiconductor device and their manufacturing methods**
Halbleiterlaser, Halbleitervorrichtung und Herstellungsverfahren
Laser à semi-conducteur, dispositif à semi-conducteur et méthode de fabrication

(30) Priority: 26.11.1998 JP 33635498; 23.04.1999 JP 11680599
(43) Date of publication of application: 31.05.2000
(73) Proprietor: SONY CORPORATION, Tokyo 141 (JP)
(72) Inventor: Asano, Takeharu, Shinagawa-ku, Tokyo (JP); Asatsuma, Tsunenori, Shinagawa-ku, Tokyo (JP); Hino, Tomonori, Shinagawa-ku, Tokyo (JP); Tomiya, Shigetaka, Shinagawa-ku, Tokyo (JP); Yamaguchi, Takashi, Shinagawa-ku, Tokyo (JP); Kobayashi, Takashi, Shinagawa-ku, Tokyo (JP)
(74) Representative: Müller - Hoffmann & Partner

(56) References cited:
- EP-A- 0 716 457
- EP-A- 0 803 916
- US-A- 4 752 933
- US-A- 5 780 873
- NAKAMURA S: "FIRST SUCCESSFUL III-V NITRIDE BASED LASER DIODES" INTERNATIONAL SYMPOSIUM ON BLUE LASER AND LIGHT EMITTING DIODES, XX, XX, 5 March 1996 (1996-03-05), pages 119-124, XP000869932

## Description

### BACKGROUND OF THE INVENTION

### Field of the Invention

This invention relates to a semiconductor laser and its manufacturing method, and also to a semiconductor device and its manufacturing method, especially suitable for application to ridge-structured semiconductor lasers using nitride III-V compound semiconductors.

### Description of Related Arts

Researches and developments of semiconductor lasers using AlGaInN or other nitride II-V compound semiconductors have recently been progressed vigorously as semiconductor lasers capable of emitting light over the range from the blue region to the ultraviolet region, which are required for higher densities of optical discs. In order to realize writable optical discs, optical outputs of at least 20 mW is required. Nakamura et al. reported on fabrication of a high-power laser using these materials (Appl. Phys. Lett., 72(1998)2014, Jpn. J. Appl. Phys., 37(1998)L627). This semiconductor laser has a ridge-shaped stripe, with its ridge side surfaces being coated with an insulating film such as SiO₂ film and its p-side electrode being configured to solely contact a portion of a p-type contact layer on the upper surface of the ridge.

The reported semiconductor laser involves problems in practical application, namely, a kink in its optical output to current characteristics and an increase of current starting immediately after supply of power. The kink demonstrates that oscillation in a higher-order mode occurs as the optical output increases. To prevent it, it is necessary to decrease the difference in refractive index between the ridge portion and the substance outside the ridge portion or to reduce the stripe width. In this case, however, since the substance outside the ridge portion is SiO₂ or air having a small refractive index, it is not easy to change the difference in refractive index. Reduction of the stripe width is attended with difficulties in the manufacturing process.

Regarding an increase of the current from just after supply of power, it is presumably caused by thermal deterioration of the active layer. To prevent it, it will be necessary to effectively release the heat generated in the active layer to the exterior. In the semiconductor laser of this type, however, since the upper surface of the ridge, except the surface of the p-type contact layer, is covered by SiO₂ with a low thermal conductivity, it is difficult to radiate the heat.

US 4,752,933 discloses a semiconductor laser using a compound semiconductor with a light-emitting active layer, a bottom cladding layer adjusted to a lower surface of the active layer, a top cladding layer adjusted to an upper surface of the active layer, a contact layer adjusted to the upper surface of the upper cladding layer and a current/light confinement layer adjusted to the lower surface of the lower cladding layer. The light/current confinement layer is formed by disposing a superlattice layer and diffusing p-type impurities into the superlattice layer except a region corresponding to the radiation region of the semiconducter laser. Outside the radiation region the superlattice is disordered and changed in a solid solution, wherein the refractive index in the disordered region is decreased.

### OBJECTS AND SUMMARY OF THE INVENTION

It is therefore an object of the invention to provide a semiconductor laser capable of stably controlling a transverse mode and preventing high order mode oscillation upon a high output power, and a manufacturing method of the semiconductor laser.

Another object of the invention is to provide a semiconductor device excellent in heat dissipation and having a long lifetime, and a manufacturing method of the semiconductor device.

According to the first aspect of the invention, there is provided a semiconductor laser using a compound semiconductor and having a ridge-shaped stripe, comprising:
a buried semiconductor layer made of a compound semiconductor at least a part of which is a non-single crystal, and burying opposite sides of the ridge.

According to the second aspect of the invention, there is provided a semiconductor laser using a nitride III-V compound and having a ridge-shaped stripe, comprising:
a buried semiconductor layer made of a nitride III-V compound semiconductor at least a part of which is a non-single crystal, and burying opposite sides of the ridge.

According to the third aspect of the invention, there is provided a manufacturing method of a semiconductor laser using a compound semiconductor and having a ridge-shaped stripe, comprising the steps of:
forming the ridge-shaped stripe;
growing a buried semiconductor layer of a compound semiconductor to cover the ridge such that at least a part of the buried semiconductor layer at opposite sides of the ridge be a non-single crystal; and
removing a part of the buried semiconductor layer from above the ridge.

According to the fourth aspect of the invention, there is provided a manufacturing method of a semiconductor laser using a nitride III-V compound semiconductor and having a ridge-shaped stripe, comprising the steps of:
forming the ridge-shaped stripe;
growing a buried semiconductor layer of a nitride III-V compound semiconductor to cover the ridge such that at leat a part of the buried semiconductor layer at opposite sides of the ridge be a non-single crystal; and
removing a part of the buried semiconductor layer from above the ridge.

In the first, second, third and fourth aspects of the invention, the semiconductor laser is typically a real index-guided semiconductor laser. The refractive index of the buried semiconductor layer is typically not larger than the refractive index of the active layer.

According to the fifth aspect of the invention, there is provided a semiconductor device comprising:
a base body made of a compound semiconductor having a projection: and
a buried semiconductor layer made of a compound semiconductor at least a part of which is a non-single crystal, and provided to bury the projection.

According to the sixth aspect of the invention, there is provided a semiconductor device comprising:
a base body made of a nitride III-V compound semiconductor and having a projection: and
a buried semiconductor layer made of a nitride III-V compound semiconductor at least a part of which is a non-single crystal, and provided to bury the projection.

According to the seventh aspect of the invention, there is provided a manufacturing method of a semiconductor device having a base body made of a compound semiconductor and having a projection, and having a buried semiconductor layer made of a compound semiconductor at least a part of which is a non-single crystal so as to bury the projection, comprising the steps of:
forming the projection;
growing a buried semiconductor layer of a compound semiconductor to cover the projection such that at least a part of the buried semiconductor layer around the projection be a non-single crystal; and
removing a part of the buried semiconductor layer from above the projection.

According to the eighth aspect of the invention, there is provided a manufacturing method of a semiconductor device having a base body made of a nitride III-V compound semiconductor and having a projection, and having a buried semiconductor layer made of a nitride III-V compound semiconductor at least a part of which is a non-single crystal so as to bury the projection, comprising the steps of:
forming the projection;
growing a buried semiconductor layer of a nitride III-V compound semiconductor to cover the projection such that at least a part of the buried semiconductor layer around the projection be a non-single crystal; and
removing a part of the buried semiconductor layer from above the projection.

In the present invention, the non-single crystalline portion contained in the buried semiconductor layer is typically polycrystalline, but may be amorphous or may include both a polycrystalline portion and an amorphous portion. The buried semiconductor layer typically includes a single crystalline portion and a polycrystalline portion, and the single crystalline portion is usually formed by epitaxial growth in a part of the buried semiconductor layer in contact with the base layer. The buried semiconductor layer typically has a columnar structure. The thickness (width) of the columnar crystal forming the buried semiconductor layer is in the range from 5 nm to 300 nm.

In the present invention, each nitride III-V compound semiconductor contains at least one group III element selected from the group consisting of Ga, Al, In, B and Tl, and at least N with or without As or P as group V elements. Examples of such nitride III-V compound semiconductors are GaN, AlGaN, AlN, GaInN, AlGaInN, InN, and so forth.

In the present invention, various kinds of compound semiconductors are usable as the material of the buried semiconductor layer, depending upon materials of the semiconductor laser or device. Examples thereof are nitride III-V compound semiconductors, AlₓGa₁₋ₓAs (0≤x≤1), (AlₓGa₁₋ₓ)_{y}In_{1-y}P (0≤x≤1, 0≤y≤1), ZnₓMg₁₋ₓS_{y}Se_{1-y} (0≤x≤1, 0≤y≤1), and so forth. More specifically, in a semiconductor laser using nitride III-V compound semiconductors, for example, usable as the material of the buried semiconductor layer are AlₓGa₁₋ₓN (0≤x≤1), AlₓGa₁₋ₓAs, (AlₓGa₁₋ₓ)_{y}In_{1-y}P, ZnₓMg₁₋ₓS_{y}Se_{1-y}, and so forth. In a GaAs semiconductor laser, usable as the material of the buried semiconductor layer are AlₓGa₁₋ₓAs and (AlₓGa₁₋ₓ)_{y}In_{1-y}P, for example. In an AlGaInP semiconductor laser, (AlₓGa₁₋ₓ)_{y}In_{1-y}P may be used as the material of the buried semiconductor layer.

In the present invention, the buried semiconductor layer, especially made of a nitride III-V compound semiconductor, is grown at a growth temperature not lower than the decomposition temperature of the growth source material and not higher than 760°C, namely, at a growth temperature not lower than 480°C and not higher than 760°C, for example, and more preferably at a growth temperature not lower than 520°C and not higher then 760°C. For growth of the buried semiconductor layer, metal organic chemical vapor deposition (MOCVD), hydride vapor phase epitaxy, halide vapor phase epitaxy (HVPE),or molecular beam epitaxy (MBE), or alternatively, electron cyclotron resonance (ECR) sputtering, for example, may be used.

In the present invention, when AlₓGa₁₋ₓAs is used as the material of the buried semiconductor layer, its growth temperature is generally 400 to 600 °C. When (AlₓGa₁₋ₓ)_{y}In_{1-y}P is used, its growth temperature is generally 400 to 600 °C. When ZnₓMg₁₋ₓS_{y}Se_{1-y} is used, its growth temperature is generally 300 to 600 °C. In these cases, the buried semiconductor layer may be grown by metal organic chemical vapor deposition (MOCVD) or molecular beam epitaxy (MBE), or alternatively, electron cyclotron resonance (ECR) sputtering.

In the semiconductor laser having the above-summarized structure and its manufacturing method according to the invention, since the portions at opposite sides of the ridge are buried by the buried semiconductor layer made of a compound semiconductor or a nitride III-V compound semiconductor at least a part of which is a non-single crystal, the entirety of the ridge can be buried with good smoothness. Therefore, heat dissipation from the ridge portion is improved, deterioration of the active layer is prevented, and the lifetime of the semiconductor laser is elongated.

Additionally, by appropriately determining the mixed crystal composition ratios of the compound semiconductor or the nitride III-V compound semiconductor forming the buried semiconductor layer, the difference in refractive index between the ridge portion and the buried semiconductor layer can be readily controlled to prevent high order mode oscillation and to remove kinks in the optical output to current curve. Therefore, the semiconductor laser can be manufactured easily without the need for an extremely narrow stripe.

Moreover, when metal organic chemical vapor deposition, hydride vapor phase epitaxial growth, halide vapor phase epitaxial growth or molecular beam epitaxy is used for growth of the buried semiconductor layer made of a nitride III-V compound semiconductor, in particular, the entirety of the ridge can be buried with good smoothness by setting the growth temperature not higher than 760 °C.

In the semiconductor device having the above-summarized structure and its manufacturing method according to the invention, since opposite sides of the projection are buried by the buried semiconductor layer made of a compound semiconductor or a nitride III-V compound semiconductor at least a part of which is a non-single crystal, the entirety of the projection can be buried with good smoothness. Therefore, in the case where the projection is a source of heat, heat dissipation from the projection is improved, deterioration of the element is prevented, and the lifetime of the semiconductor device is elongated.

Moreover, when metal organic chemical vapor deposition, hydride vapor phase epitaxial growth, halide vapor phase epitaxial growth or molecular beam epitaxy is used for growth of the buried semiconductor layer made of a nitride III-V compound semiconductor, in particular, the entirety of the projection can be buried with good smoothness by setting the growth temperature not higher than 760 °C.

The above, and other, objects, features and advantage of the present invention will become readily apparent from the following detailed description thereof which is to be read in connection with the accompanying drawings.

### BRIEF DESCRIPTION OF THE DRAWINGS

Fig. 1 is a cross-sectional view for explaining a method for making a sample used for a preliminary experiment;
Fig. 2 is a cross-sectional view for explaining the method for fabricating the sample used for the preliminary experiment;
Fig. 3 is a cross-sectional view for explaining the method for fabricating the sample used for the preliminary experiment;
Fig. 4 is a cross-sectional view of a ridge portion and its neighboring AlGaN buried layer grown under the growth temperature of 800 °C;
Fig. 5 is a cross-sectional view of a ridge portion and its neighboring AlGaN buried layer grown under the growth temperature of 760 °C;
Fig. 6 a cross-sectional view of a ridge portion and its neighboring AlGaN buried layer grown under the growth temperature of 730 °C;
Fig. 7 is a schematic diagram showing the structure of an AlGaN buried layer grown under the growth temperature of 520 °C;
Fig. 8 is a schematic diagram showing the structure of an AlGaN buried layer grown under the growth temperature of 730 °C;
Fig. 9 is a schematic diagram showing the structure of an AlGaN buried layer grown under the growth temperature of 760 °C;
Fig. 10 is a perspective view showing a GaN compound semiconductor laser having a buried ridge structure according to the first embodiment of the invention;
Fig. 11 is a cross-sectional view for explaining a manufacturing method of the GaN compound semiconductor laser having the buried ridge structure according to the first embodiment of the invention;
Fig. 12 is a cross-sectional view for explaining the manufacturing method of the GaN compound semiconductor laser having the buried ridge structure according to the first embodiment of the invention;
Fig. 13 is a cross-sectional view for explaining the manufacturing method of the GaN compound semiconductor laser having the buried ridge structure according to the first embodiment of the invention;
Fig. 14 is a cross-sectional view for explaining the manufacturing method of the GaN compound semiconductor laser having the buried ridge structure according to the first embodiment of the invention;
Fig. 15 is a cross-sectional view for explaining the manufacturing method of the GaN compound semiconductor laser having the buried ridge structure according to the first embodiment of the invention;
Fig. 16 is a cross-sectional view for explaining the manufacturing method of the GaN compound semiconductor laser having the buried ridge structure according to the first embodiment of the invention;
Fig. 17 is a cross-sectional view for explaining the manufacturing method of the GaN compound semiconductor laser having the buried ridge structure according to the first embodiment of the invention;
Fig. 18 is a cross-sectional view for explaining the manufacturing method of the GaN compound semiconductor laser having the buried ridge structure according to the first embodiment of the invention;
Fig. 19 is a schematic diagram showing a result of measurement on optical output to current characteristics of the GaN semiconductor laser having the buried ridge structure according to the first embodiment of the invention;
Fig. 20 is a perspective view of a GaN semiconductor laser having a buried ridge structure according to the second embodiment of the invention; and
Fig. 21 is a perspective view of a GaN semiconductor laser having a buried ridge structure according to the third embodiment of the invention.

### DETAILED DESCRIPTION OF THE PREFERRED EMBODIMENTS

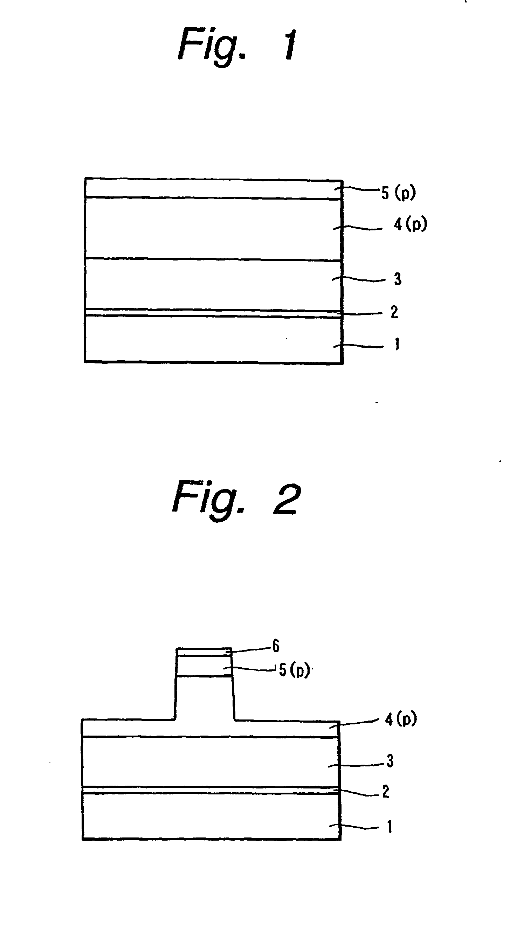

Before explaining embodiments of the invention, explanation is made on a result of preliminary experiment executed to evaluate the burying property of the buried layer and the crystalline property of the buried layer. Figs. 1 through 3 show a method for making a sample for evaluation.

First referring to Fig. 1, an undoped GaN buffer layer 2 is grown by MOCVD under a temperature around 520 °C, for example, on a c-plane sapphire substrate 1 with a previously cleaned surface by thermal cleaning, for example. Thereafter, at the growth temperature of 1000 °C, an undoped GaN layer 3, p-type AlGaN buried layer 4 and p-type GaN layer 5 are sequentially grown on the GaN buffer layer 2 by MOCVD. Source materials for growing these GaN compound semiconductor layers may be, for example, trimethyl gallium ((CH₃)₃Ga, TMG) as the source material of the group III element Ga, trimethyl aluminum ((CH₃)₃Al, TMA) as the source material of the group III element Al, trimethyl indium ((CH₃)₃In, TMI) as the source material of group III element In, and ammonium (NH₃) as the source material of the group V element N. The carrier gas may be a mixed gas of hydrogen (H₂) and nitrogen (N₂), for example. Regarding dopants, usable are, for example, mono silane (SiH₄) and the n-type dopant and bis=methyl cyclopentadienyl magnesium (CH₃C₅H₄)₂Mg) or bis=cyclopentadienyl magnesium ((C₅H₅)₂Mg) as the p-type dopant.

After that, the c-plane sapphire substrate 1 having grown the GaN semiconductor layer is removed from the MOCVD apparatus. Then, as shown in Fig. 2, after making a SiO₂ film 6, 0.4 µm thick, on the entire surface of the p-type GaN layer 5 by CVD, vacuum evaporation, sputtering, or the like, a resist pattern (not shown) of a predetermined pattern is formed on the SiO₂ film 6 by lithography. Then, using the resist pattern as a mask, the SiO₂ film 6 is etched to shape it into a stripe by wet etching using an etchant selected from a series of hydrofluoric acids, for example, or reactive ion etching (RIE) using an etching gas such as CF₄ or CHF₃ containing fluorine. Thereafter, using the SiO₂ film 6 as a mask, the p-type AlGaN buried layer 4 is etched to a certain depth thereof by RIE, for example, to form the ridge portion. The etching gas for RIE may be, for example, a chlorine-based gas.

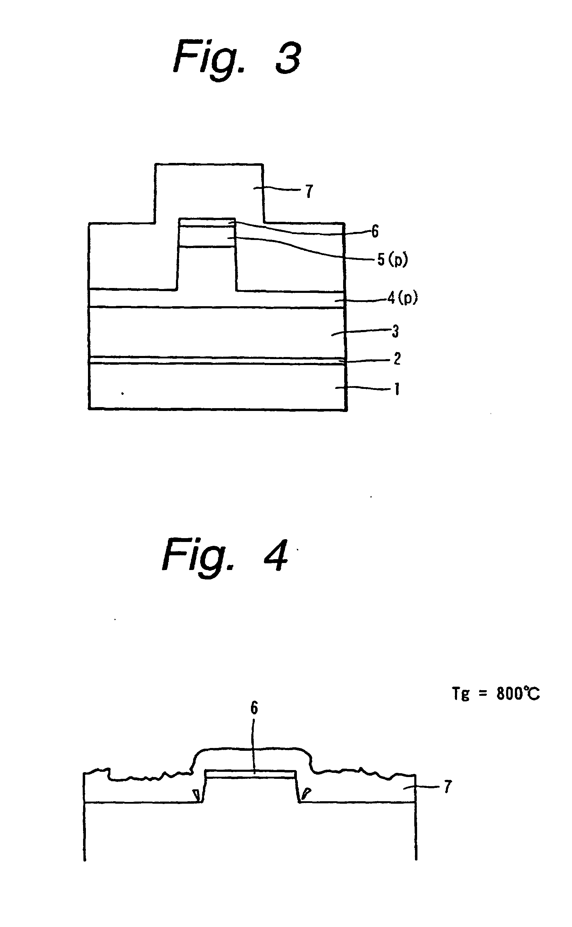

Next referring to Fig. 3, again by MOCVD, an AlGaN buried layer 7 containing Al by 60%, for example, is grown on the entire substrate surface to bury opposite sides of the ridge portion.

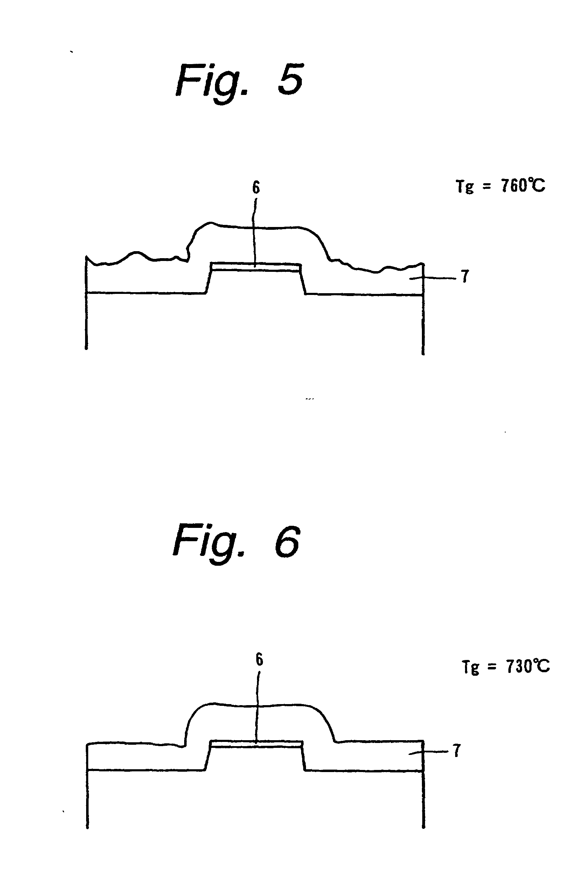

Figs. 4 through 6 are diagrams drawn from scanning electronic microscopic photographs (SEM photographs) of cross sections of the ridge portion and adjacent AlGaN buried layer 7 in a sample prepared by setting the growth temperature (Tg) at 800 °C, 760 °C and 730 °C, respectively, for growth of the AlGaN buried layer 7. As apparent from Figs. 4 through 6, when the growth temperature is 800 °C, the AlGaN buried layer 7 fails to bury portions along side surfaces of the ridge portion (hollow spaces). The surface of the AlGaN buried layer 7 is flat when the growth temperature is 730 °C, but becomes uneven as the growth temperature increases. The AlGaN buried layer 7 is single-crystalline when the growth temperature is 800 °C, but it is partly columnar-structured when the growth temperature is 760 °C. Additionally, when the growth temperature is 900 °C, although not shown, unevenness on the surface of the AlGaN buried layer 7 is not so large, but cracks are produced in the AlGaN buried layer 7. As reviewed above, the use of a single crystal layer to bury the ridge portion involves the problems, failure to bury side surfaces of the ridge portion, large unevenness on the surface and generation of cracks. Therefore, in order to reliably bury the ridge side surfaces and prevent cracks, the semiconductor layer used to bury the ridge portion must be polycrystalline at least partly. Additionally, from the viewpoint of facilitating the laser process after the ridge is buried and from the viewpoint of ensuring close contact of the buried layer with the electrode to improve heat dissipation, unevenness on the surface of the AlGaN buried layer 7 is desirably as small as possible. Taking them into consideration, the growth temperature for growing the AlGaN buried layer 7 by MOCVD is preferably not higher than 760 °C.

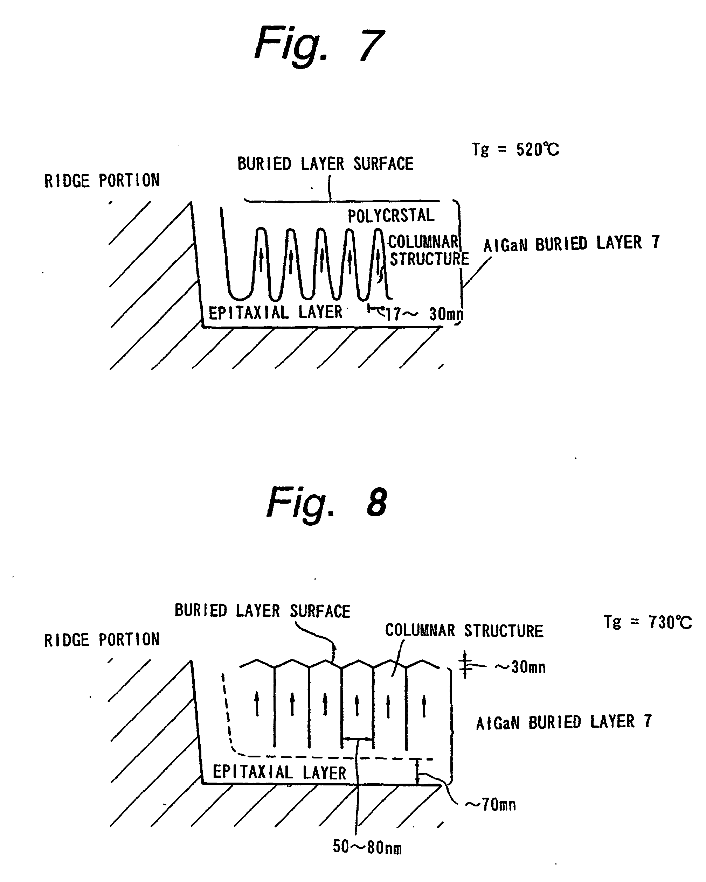

Figs. 7 through 9 schematically show cross-sectional structures of AlGaN buried layers 7 observed through a transmission electronic microscope (TEM) in samples prepared by setting the growth temperature (Tg) at 520 °C, 730 °C and 760 °C, respectively, for growth of the AlGaN buried layer 7.

As shown in Fig. 7, when the growth temperature is 520 °C, the AlGaN buried layer 7 is epitaxially grown from the base layer as a single crystal at a part thereof in contact with the base layer, and the crystal grows thereon in form of columns to form a columnar structure. Thickness of the epitaxial layer was approximately 70 nm. Diameter of lower portions of columnar crystals were 50 through 80 nm. Unevenness as high as approximately 30 nm was produced on the surface of the AlGaN buried layer 7.

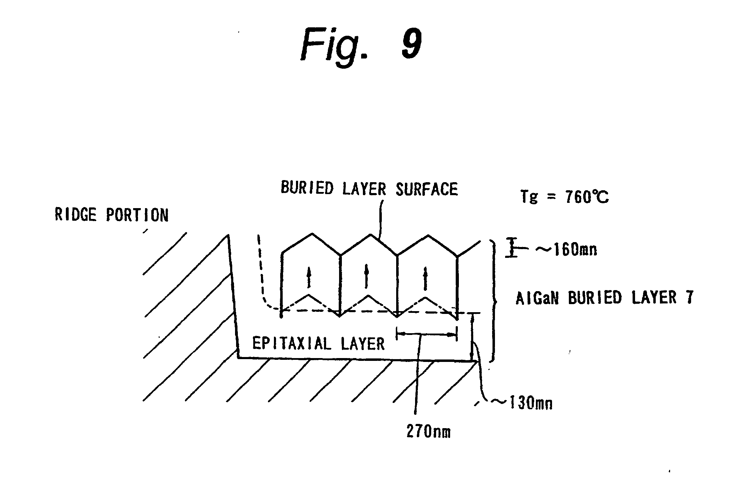

As shown in Fig. 9, under the growth temperature of 760 °C, the part of the AlGaN buried layer 7 in contact with the base layer exhibits a faultless single crystal epitaxially grown from the base layer, and above it, the crystal growc in a columnar form to make a columnar structure. Thickness of the epitaxial layer was approximately 130 nm, and diameter of a lower part of each columnar crystal was approximately 270 nm. These columnar crystals are substantially aligned in orientation. Further, a large number of planar defects were introduced into respective columnar crystals. There was unevenness as high as approximately 160 nm on the surface of the AlGaN buried layer 7.

Now made below is explanation on embodiments of the invention with reference to the drawings. In all of the drawings illustrating embodiments, the same or equivalent components are labeled with common reference numerals.

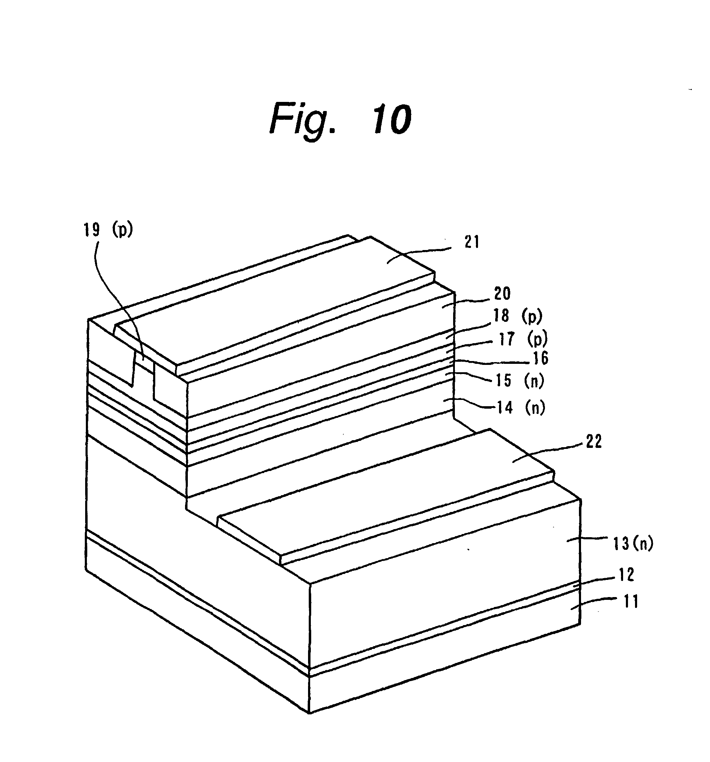

Fig. 10 shows a GaN compound semiconductor laser having a buried ridge structure according to the first embodiment of the invention. The GaN compound semiconductor laser shown here has a SCH structure(separate confinement heterostructure).

As shown in Fig. 10, the GaN semiconductor laser according to the first embodiment includes an n-type GaN contact layer 13, n-type AlGaN cladding layer 14, n-type GaN optical guide layer 15, active layer 16 having an undoped Ga₁₋ₓInₓN/Ga_{1-y}In_{y}N multi quantum well structure, p-type GaN optical guide layer 17, p-type AlGaN cladding layer 18 and p-type GaN contact layer 19 sequentially stacked on a c-plane sapphire substrate 11 having the thickness of 400 µm, for example, via an undoped GaN buffer layer 12.

The GaN buffer layer 12 is 30 nm thick, for example. The n-type GaN contact layer 13 is 4 µm thick, for example, and doped with silicon (Si), for example, as its n-type impurity. The n-type AlGaN cladding layer 14 is 0.7 µm thick, for example, and doped with Si, for example, as its n-type impurity. The n-type GaN optical guide layer 15 is 0.1 µm thick, for example, and doped with Si, for example, as its n-type impurity. In the active layer having the undoped Ga₁₋ₓInₓN/Ga_{1-y}In_{y}N multi quantum well structure, each well layer is 3 nm thick and each barrier layer is 4 nm thick, for example.

The p-type GaN optical guide layer 17 is 0.1 µm thick, and doped with magnesium (Mg), for example, as its p-type impurity. The p-type AlGaN cladding layer 18 is 0.7 µm thick, for example, and doped with Mg, for example, as its p-type impurity. The p-type GaN contact layer 19 is 0.3 µm thick, for example, and doped with Mg, for example, as its p-type impurity.

The upper-lying portion of the n-type GaN contact layer 13, n-type AlGaN cladding layer 14, n-type GaN optical guide layer 15, active layer 16, p-type GaN optical guide layer 17 and p-type AlGaN cladding layer 18 have a mesa configuration of a predetermined width. In the mesa portion, the upper-lying portion of the p-type AlGaN cladding layer 18 and the p-type GaN contact layer 19 form a ridge portion with a predetermined width extending in one direction. The extending direction of the ridge portion may be <11-20> direction, for example, and the width is 4 µm, for example.

At opposite sides of the ridge portion, an undoped AlGaN buried layer 20, for example, is provided. The AlGaN buried layer 20 is polycrystalline (or columnar-structured) at least partly.

In the ridge portion, a p-side electrode 21 is provided on the p-type GaN contact layer 19 and its adjacent portions of the AlGaN buried layer 20. The p-side electrode 21 has a Ni/Pt/Au structure sequentially stacking an Ni film, Pt film and Au film, for example, and these Ni film, Pt film and Au film are 10 nm thick, 100 nm thick and 300 nm thick, respectively, for example. Since the AlGaN buried layer 20 has a high resistance, current flows merely in the ridge stripe portion regardless of the p-side electrode 21 being in contact with both the GaN contact layer 19 and the AlGaN buried layer 20. In the region other than the mesa portion, an n-side electrode 22 is provided on the n-type GaN contact layer 13. The n-side electrode 22 has a Ti/Al/Pt/Au structure sequentially stacking a Ti film, Al film, Pt film and Au film, for example, and these Ti film, Al film, Pt film and Au film are 10 nm thick, 100 nm thick, 100 nm thick and 300 nm thick, respectively, for example.

Next explained is a manufacturing method of the GaN semiconductor laser having the above-explained structure according to the first embodiment.

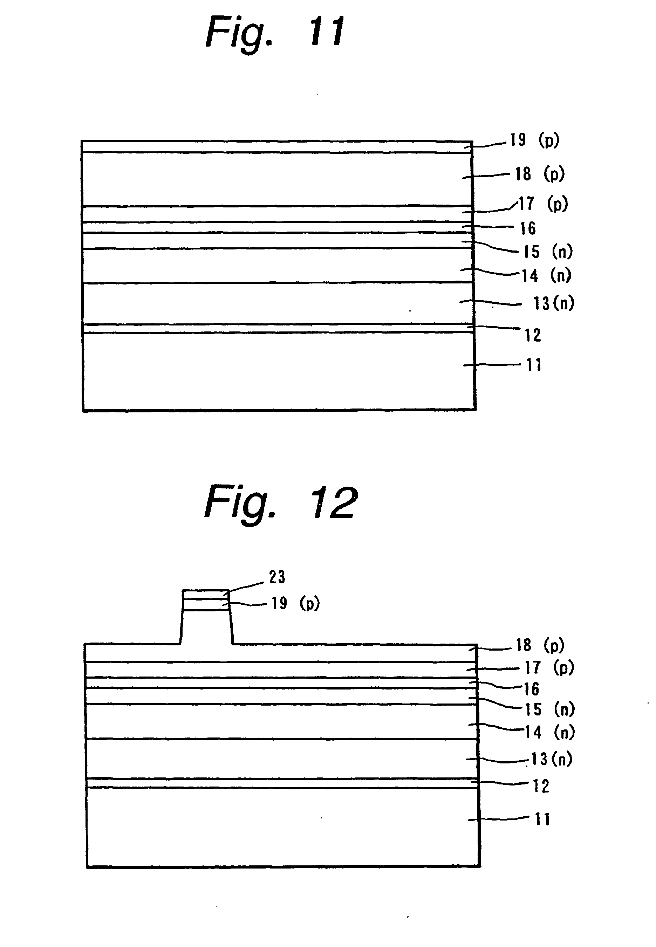

For manufacturing the GaN semiconductor laser, first as shown in Fig. 11, an undoped GaN buffer layer 12 is grown by MOCVD under a temperature around 520 °C, for example, on a c-plane sapphire substrate 11 with a previously cleaned surface by thermal cleaning, for example. Thereafter, the substrate temperature is increased to a predetermined growth temperature, and an n-type GaN layer 3, n-type AlGaN cladding layer 14, n-type GaN optical guide layer 15, active layer 16 having the undoped Ga₁₋ₓInₓN/Ga_{1-y}In_{y}N multi quantum well structure, p-type GaN optical guide layer 17, p-type AlGaN cladding layer 18 and p-type GaN contact layer 19 are sequentially stacked on the GaN buffer layer 12. For layers not containing In, namely, n-type GaN contact layer 13, -type AlGaN cladding layer 14, n-type GaN optical guide layer 15, p-type GaN optical guide layer 17, p-type AlGaN cladding layer 18 and p-type GaN contact layer 19, the growth temperature is set to 1000°C, for example. For the active layer 16 having the Ga₁₋ₓInₓN/Ga_{1-y}In_{y}N multi quantum well structure, which contains In, the growth temperature is set to 700 through 800°C, for example. Source materials for growing these GaN compound semiconductor layers may be, for example, trimethyl gallium ((CH₃)₃Ga, TMG) as the source material of the group III element Ga, trimethyl aluminum ((CH₃)₃Al, TMA) as the source material of the group III element Al, trimethyl indium ((CH₃)₃In, TMI) as the source material of group III element In, and ammonium (NH₃) as the source material of the group V element N. The carrier gas may be a mixed gas of hydrogen (H₂) and nitrogen (N₂), for example. Regarding dopants, usable are, for example, mono silane (SiH₄) and the n-type dopant and bis=methyl cyclopentadienyl magnesium ((CH₃C₅H₄)₂Mg) or bis= cyclopentadienyl magnesium ((C₅H₅)₂Mg) as the p-type dopant.

After that, the c-plane sapphire substrate 11 having grown the GaN semiconductor layer is removed from the MOCVD apparatus. Then, as shown in Fig. 12, after making a SiO₂ film 23, 0.4 µm thick, on the entire surface of the p-type GaN contact layer 19 by CVD, vacuum evaporation, sputtering, or the like, a resist pattern (not shown) of a predetermined pattern is formed on the SiO₂ film 23 by lithography. Then, using the resist pattern as a mask, the SiO₂ film 23 is etched to shape it into a stripe by wet etching using an etchant selected from a series of hydrofluoric acids, for example, or RIE using an etching gas such as CF₄ or CHF₃ containing fluorine. Thereafter, using the SiO₂ film 23 as a mask, the p-type AlGaN cladding layer 18 is etched to a certain depth thereof by RIE, for example, to form the ridge portion. The etching gas for RIE may be, for example, a chlorine-based gas.

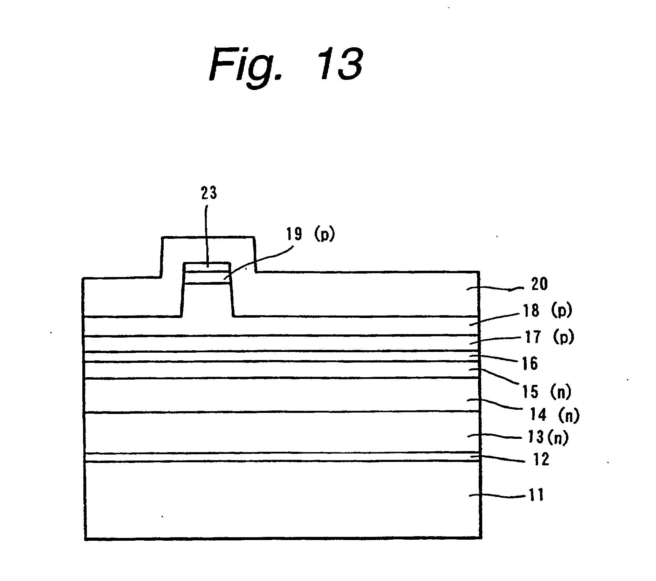

Next referring to Fig. 13, again by MOCVD, setting the growth temperature to 520°C, for example, an AlGaN buried layer 20 containing Al by 60%, for example, is grown on the entire substrate surface to bury opposite sides of the ridge portion. Under the growth temperature of 520°C, at least a part of the AlGaN buried layer 20 becomes polycrystalline. In this case, no crack is produced in the AlGaN buried layer 20 even with the Al composition of 60%. At the same time, the entirety of the ridge can be buried with good smoothness.

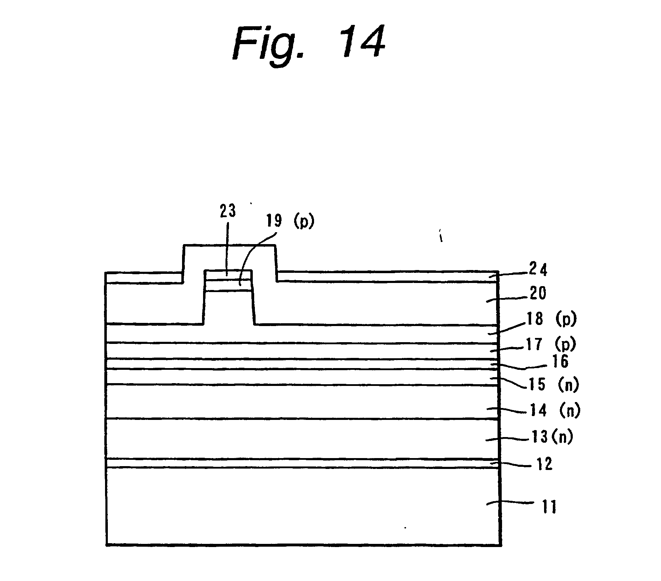

After that, the c-plane sapphire substrate 11 having the AlGaN buried layer 20 grown thereon is removed by the MOCVD apparatus. Then, as shown in fig. 14, after a SiO₂ film 24, 0.4 µm thick, for example, is formed on the entire substrate surface by CVD, vacuum evaporation or sputtering, for example, a resist pattern (not shown) of a predetermined configuration is made by lithography on the SiO₂ film 24 excluding the projecting portion of the AlGaN buried layer 20. Then, using the resist pattern as a mask, the SiO₂ film 24 is etched by wet etching using an etchant selected from a series of hydrofluoric acids, for example, or RIE using an etching gas such as CF₄ or CHF₃ containing fluorine.

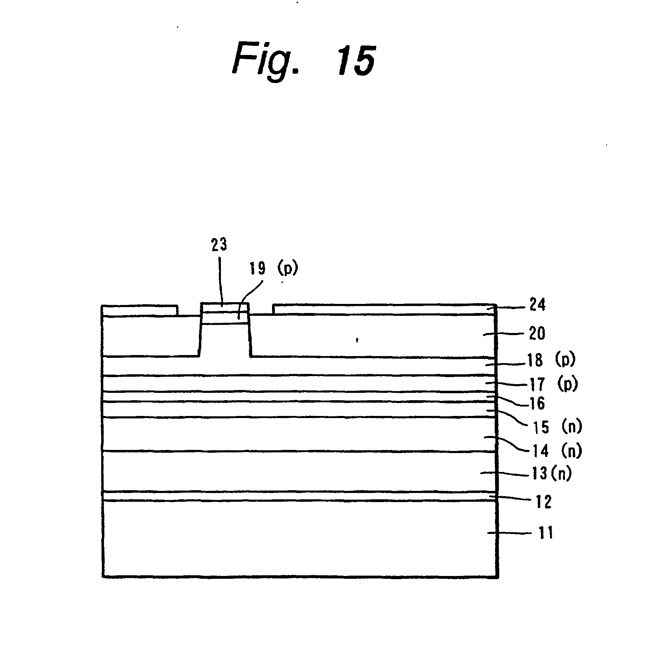

Thereafter, as shown in Fig. 15, using the SiO₂ film 24 as a mask, etching is conducted by RIE, for example, to remove the projecting portion of the AlGaN buried layer 20 above the ridge portion.

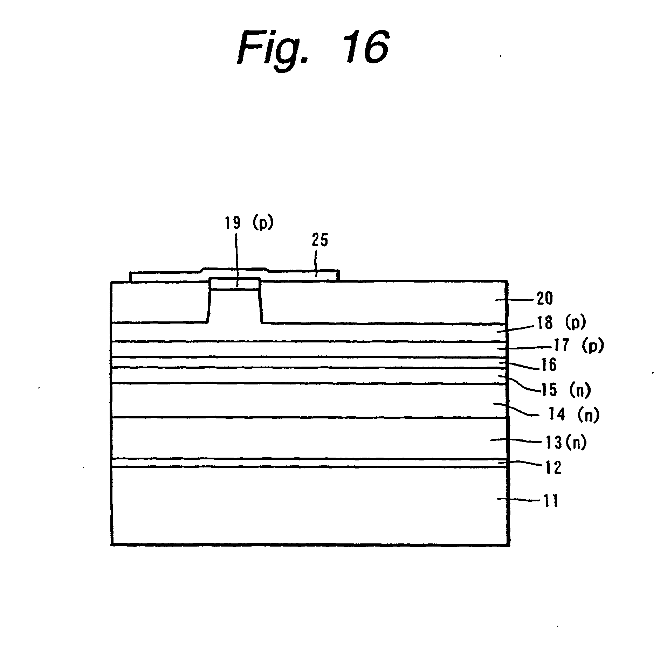

After that, the SiO₂ film 24 is removed, and a SiO₂ film 25 with a predetermined configuration is formed on the substrate surface in the same process as explained above as shown in Fig. 16.

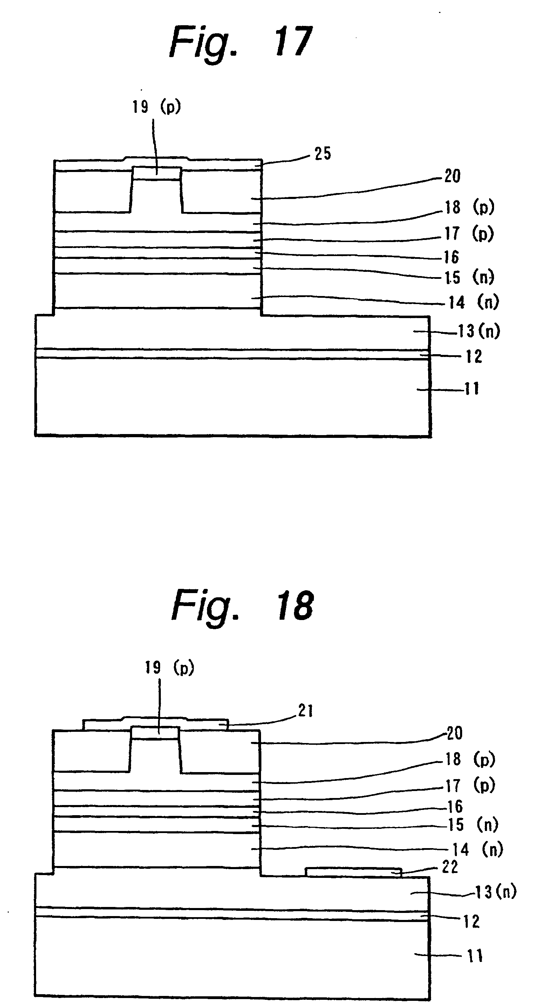

Thereafter, as shown in Fig. 17, using the SiO₂ film 25 as a mask, etching is conducted by RIE, for example, until exposing the n-type GaN contact layer 13, to pattern the upper-lying portion of the n-type GaN contact layer 13, n-type AlGaN cladding layer 14, n-type GaN optical guide layer 15, active layer 16 with the undoped Ga₁₋ₓInₓN/Ga_{1-y}In_{y}N multi quantum well structure, p-type GaN optical guide layer 17, p-type AlGaN cladding layer 18 and AlGaN buried layer 20 into a mesa configuration.

Then, the SiO₂ film 25 is removed by etching. After that, a resist pattern (not shown) of a predetermined configuration is formed on the substrate surface, and a Ti film, Al film, Pt film and Au film are formed sequentially on the entire substrate surface by vacuum evaporation, for example. Then, the resist pattern is removed together with the overlying Ti film, Al film, Pt film and Au film (lift-off). As a result, as shown in Fig. 18, the n-side electrode 22 is formed on a location of the n-type GaN contact layer 13 adjacent to the mesa portion. Thereafter, the n-side electrode 22 is alloyed for ohmic contact. The p-side electrode 21 is also formed in a similar process in the mesa portion on the p-type GaN contact layer 19 and its adjacent portions of the AlGaN buried layer 20, and it is alloyed for ohmic contact.

After that, the c-plane sapphire substrate 11 having formed the laser structure thereon is divided into bars by cleavage, for example, to form cavity edges. The cavity edges are next coated by edge coating, and each bar is divided into chips by cleavage, for example. Through these steps, the intended buried ridge structured and SCH structured GaN compound semiconductor laser is completed as shown in Fig. 10.

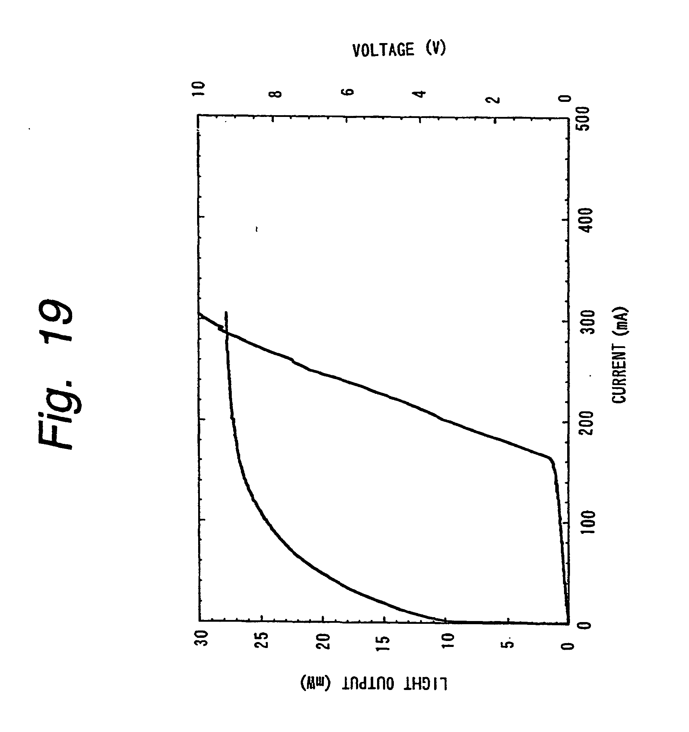

Fig. 19 shows a result of measurement on optical output to current characteristics of the GaN compound semiconductor laser according to the first embodiment. The growth temperature of the AlGaN buries layer 20 is 520 °C. It is noted from Fig. 19 that good optical output to current characteristics were obtained.

As explained above, according to the first embodiment, since the ridge is buried by the AlGaN buried layer 20 grown at the growth temperature of 520 °C to be polycrystalline at least partly, the entirety of the ridge can be buried with good surface smoothness without producing cracks in the AlGaN buried layer 20 even with a high Al composition. Additionally, since the contact area between the p-side electrode 21 and the base layer can be increased, it is possible to effectively release heat generated during operation and prevent an increase of the current during supply of power to thereby elongate the lifetime of the semiconductor laser. Additionally, by changing the Al composition in the AlGaN buried layer 20, the difference in refractive index between the ridge portion and the remainder portion can be controlled, and transverse modes can be controlled easily.

Moreover, the first embodiment also has the following advantage. That is, in case of growth of GaN semiconductors, in general, there is the problem that a p-type impurity (acceptor) in grown layers is inactivated by hydrogen in the growth atmosphere, and there is the need for post-annealing in a nitrogen atmosphere after growth of p-type layers. In the first embodiment, however, since the outer-most surface is the AlGaN buried layer 20 during growth of the AlGaN buried layer 20, hydrogen in the growth atmosphere does not directly attack p-type layers, and hydrogen caught into p-type layers during first epitaxial growth for growing layers up to the p-type GaN contact layer 19 may leave therefrom through the AlGaN buried layer 20. Therefore, p-type impurities in p-type layers can be activated during growth of the AlGaN buried layer 20 without executing post-annealing.

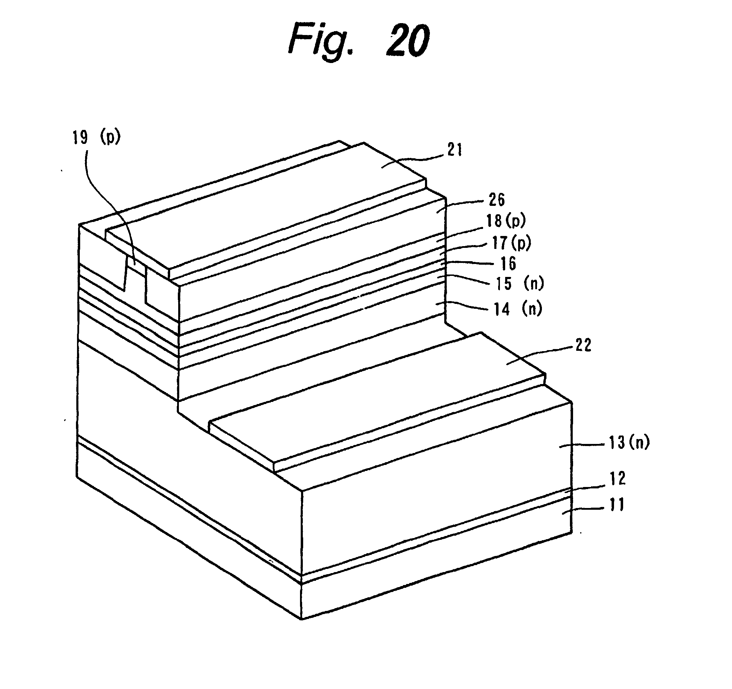

Fig. 20 shows a GaN compound semiconductor layer having a buried ridge structure according to the second embodiment of the invention. This GaN compound semiconductor laser also has a SCH structure.

As shown in Fig. 20, in the GaN compound semiconductor laser according to the second embodiment, a high-resistance AlN buried layer 26 is buried at opposite sides of the ridge portion. At least a part of the AlN buried layer 26 is polycrystalline. In the other respects, the GaN compound semiconductor laser shown here is the same as that of the first embodiment. So, their explanation is omitted.

The method for manufacturing the GaN compound semiconductor laser according to the second embodiment is the same as the manufacturing method of the GaN compound semiconductor laser according to the first embodiment except that the AlN buried layer 26 is made by ECR sputtering.

According to the second embodiment, since the ridge is buried by the AlGaN buried layer 20 grown by ECR sputtering to be polycrystalline at least partly, the entirety of the ridge can be buried with good surface smoothness without producing cracks in the AlGaN buried layer 20. Additionally, since the contact area between the p-side electrode 21 and the base layer can be increased, it is possible to effectively release heat generated during operation and prevent an increase of the current during supply of power thereby to elongate the lifetime of the semiconductor laser. Additionally, since the refractive index of the AlN buried layer 26 is larger than that of SiO₂ or air, the difference in refractive index between the ridge portion and the remainder portion can be reduced as compared with conventional ridge-structured GaN compound semiconductor lasers, and transverse modes can be stabilized. Furthermore, since the AlN buried layer 26 is made by ECR sputtering, the burying process is easier.

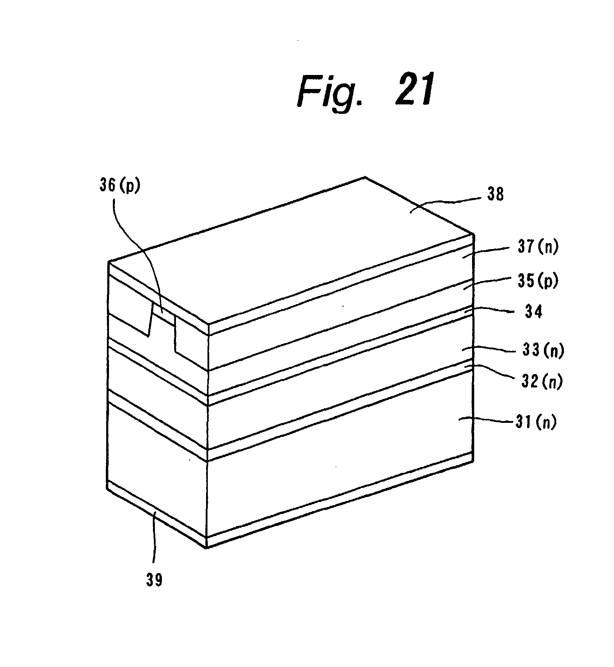

Fig. 21 shows a GaAs compound semiconductor laser having a buried ridge structure according to the third embodiment of the invention.

As shown in Fig. 21, the GaAs compound semiconductor laser according to the third embodiment includes an n-type GaAs buffer layer 32, n-type AlGaAs cladding layer 33, active layer 34 with a single quantum well structure or a multi quantum well structure, p-type AlGaAs cladding layer 35 and p-type GaAs cap layer 36 which are sequentially stacked on an n-type GaAs substrate 31. An upper-lying portion of the p-type AlGaAs cladding layer 35 and the p-type GaAs cap layer 36 form a ridge portion of a predetermined width extending in one direction.

On opposite sides of the ridge portion, an n-type AlGaAs buried layer 37, for example, is buried. At least a part of the n-type AlGaAs buried layer 37 is made up of a polycrystalline or amorphous region.

In the ridge portion, a p-side electrode 38 is provided on the p-type GaAs cap layer 36 and its adjacent portions of the n-type AlGaAs buried layer 37. The p-side electrode 38 may be, for example, a Ti/Pt/Au electrode. On the bottom surface of the n-type GaAs substrate 31, an n-side electrode 39 is provided in ohmic contact with the n-type GaAs substrate 31. The n-side electrode 39 may be, for example, a AuGe/Ni electrode or an In electrode.

Next explained is a manufacturing method of the GaAs compound semiconductor laser having the above-explained structure according to the third embodiment.

For manufacturing the GaAs compound semiconductor laser, first as shown in Fig. 21, the n-type GaAs buffer layer 32, n-type AlGaAs cladding layer 33, active layer 34, p-type AlGaAs cladding layer 35 and p-type GaAs cap layer 36 are sequentially grown on the n-type GaAs substrate 31 by metal organic chemical vapor deposition (MOCVD), for example, at a growth temperature around 800 °C, for example.

After that, the n-type GaAs substrate 31 having the AlGaAs compound semiconductor layers grown thereon is removed from the MOCVD apparatus. Subsequently, after a SiO₂ film, 0.4 µm thick, for example, is formed on the entire surface of the p-type GaAs cap layer 36 by CVD, vacuum evaporation or sputtering, for example, a resist pattern (not shown) of a predetermined configuration is formed on the SiO₂ film by lithography. Using the resist pattern as a mask, the SiO₂ film is etched to shape it into a stripe by wet etching using an etchant selected from a series of hydrofluoric acids, for example, or RIE using an etching gas such as CF₄ or CHF₃ containing fluorine. Then, using the SiO₂ film as a mask, the p-type AlGaAs cladding layer 35 is etched to a predetermined depth by wet etching or dry etching to form a ridge portion.

After that, the n-type AlGaAs buried layer is grown on the entire surface again by MOCVD at the growth temperature of 450 °C, for example, to bury opposite sides of the ridge portion. Under the growth temperature of 450 °C, the n-type AlGaAs buried layer 37 becomes polycrystalline or amorphous at least partly. In this case, no cross hatching is produced in the n-type AlGaAs buried layer 37, and the entire ridge can be buried with good surface smoothness.

Thereafter, the n-type GaAs substrate 31 having the n-type AlGaAs buried layer 37 thereon is removed from the MOCVD apparatus. Then, after a SiO₂ film, 0.4 µm thick, for example, is formed on the entire surface of the substrate by CVD, vacuum evaporation or sputtering, for example, a resist pattern (not shown) of a predetermined configuration is formed on the SiO₂ film except the exposed portion of the n-type AlGaAs buried layer 37 by lithography. Using the resist pattern as a mask, the SiO₂ film is etched to shape it into a stripe by wet etching using an etchant selected from a series of hydrofluoric acids, for example, or RIE using an etching gas such as CF₄ or CHF₃ containing fluorine.

After that, using the SiO₂ film as a mask, etching by wet etching or RIE, for example, is conducted to remove the projecting portion of the n-type AlGaAs buried layer 37 above the ridge portion. Thereafter, the SiO₂ film is removed by etching.

After that, a Ti film, Pt film and Au film are sequentially stacked on the entire surface of the substrate by vacuum evaporation, for example, to form the p-side electrode 38. On the bottom surface of the n-type GaAs substrate 31, a AuGe/Ni film or an In film is formed as the n-side electrode 39.

Subsequently, the n-type GaAs substrate 31 having formed the laser structure thereon is devided into bars by cleavage, for example, to form cavity edges. The cavity edges are next coated by edge coating, and each bar is devided into chips by cleavage, for example. Through these steps, the intended buried ridge structured GaAs compound semiconductor laser is completed.

According to the third embodiment, the same advantages as those of the first embodiment can be obtained in ridge-structured GaAs semiconductor lasers.

Having described specific preferred embodiments of the present invention with reference to the accompanying drawings, it is to be understood that the invention is not limited to those precise embodiments, and that various changes and modifications may be effected therein by one skilled in the art without departing from the scope of the invention as defined in the appended claims.

For example, numerical values, structures, substrates, source materials and processes proposed in the first, second and third embodiments are not but examples, and other appropriate numerical values, structures, substrates, source materials and processes may be used, if necessary.

Although the first and second embodiments have been explained as extending the ridge stripe portion in the <11-20> orientation of the c-plane sapphire substrate 11, it may instead extend in the <1-100> direction.

Although the first and second embodiments have been explained as using the c-plane sapphire substrate as the substrate, a SiC substrate, Si substrate of spinel substrate, for example, may be used where appropriate.

Further, the first and second embodiments have been explained as applying the invention to SCH-structured GaN compound semiconductor lasers. However, the invention is also applicable to GaN compound semiconductor lasers having a DH structure (double heterostructure), for example.

The third embodiment has been explained as applying the invention to GaAs compound semiconductor lasers having a DH structure (double heterostructure). However, it is applicable to SCH-structured GaAs compound semiconductor lasers as well.

As described above, according to the semiconductor laser, since opposite sides of the ridge are buried by the buried semiconductor layer made of a compound semiconductor or a nitride III-V compound semiconductor at least a part of which is a non-single crystal, high-order mode oscillation can be prevented by stably controlling transverse modes, and excellent heat dissipation is ensured.

According to the manufacturing method of a semiconductor laser according to the invention, the semiconductor laser having the said advantages can be manufactured easily.

According to the semiconductor device according to the invention, since opposite sides of the projection are buried by the buried semiconductor layer made of a compound semiconductor or a nitride III-V compound semiconductor at least a part of which is a non-single crystal, and excellent heat dissipation is ensured.

According to the manufacturing method of a semiconductor device according to the invention, the semiconductor device having the said advantages can be manufactured easily.

## Claims

1. A semiconductor laser using a compound semiconductor and having a ridge-shaped stripe, comprising:
a buried semiconductor layer made of a compound semiconductor at least a part of which is a non-single crystal, and burying opposite sides of the ridge
**characterized in that**
said buried semiconductor layer is at least partly polycrystalline.

2. A semiconductor laser according to claim 1, wherein said semiconductor laser uses a nitride III-V compound semiconductor.

3. The semiconductor laser according to claim 1 or 2, wherein said buried semiconductor layer is made of a nitride III-V compound semiconductor.

4. The semiconductor laser according to claim 3, wherein said buried semiconductor layer includes a region of a single crystal and a region of a polycrystal.

5. The semiconductor laser according to claim 3. wherein said buried semiconductor layer has a columnar structure.

6. The semiconductor laser according to claim 5 wherein diameter of a columnar crystal forming said buried semiconductor layer is in the range from 5 nm to 300 nm.

7. The semiconductor laser according to claim 3. wherein said buried semiconductor layer has a refractive index not higher than that of an active layer.

8. The semiconductor laser according to claim 3. wherein said buried semiconductor layer is made of AlxGa1-xN (0≤x≤1).

9. The semiconductor laser according to claim 3. wherein said semiconductor laser is a real index-guided semiconductor laser.

10. A manufacturing method of a semiconductor laser using a compound semiconductor and having a ridge-shaped stripe, comprising the steps of:
forming said ridge-shaped stripe;
growing a buried semiconductor layer of a compound semiconductor to cover the ridge at a growth temperature such that at least a part of said buried semiconductor layer at opposite sides of the ridge be a polycrystal; and
removing a part of said buried semiconductor layer from above said ridge.

11. A manufacturing method of a semiconductor laser according to claim 10, wherein said semiconductor laser uses a nitride III-V compound semiconductor.

12. The manufacturing method of a semiconductor laser according to claim 11, wherein said buried semiconductor layer is made of a nitride III-V compound semiconductor.

13. The manufacturing method of a semiconductor laser according to claim 12, wherein said buried semiconductor layer includes a region of a single crystal and a region of a polycrystal.

14. The manufacturing method of a semiconductor laser according to claim 12, wherein said buried semiconductor layer has a columnar structure.

15. The manufacturing method of a semiconductor laser according to claim 14, wherein diameter of a columnar crystal forming said buried semiconductor layer is in the range from 5 nm to 300 nm.

16. The manufacturing method of a semiconductor laser according to claim 12, wherein said buried semiconductor layer is grown under a growth temperature not lower than the decomposition temperature of a source material for growth thereof and not higher than 760 °C.

17. The manufacturing method of a semiconductor laser according to claim 12, wherein said buried semiconductor layer is grown under a growth temperature in the range from 480 °C to 760 °C.

18. The manufacturing method of a semiconductor laser according to claim 12, wherein said buried semiconductor layer is grown under a growth temperature in the range from 520 °C to 760 °C.

19. The manufacturing method of a semiconductor laser according to claim 12, wherein said buried semiconductor layer is grown by metal organic chemical vapor deposition, hydride vapor phase epitaxial growth or molecular beam epitaxy.

20. The manufacturing method of a semiconductor laser according to claim 12, wherein said buried semiconductor layer is grown by electron cyclotron resonance sputtering.

21. The manufacturing method of a semiconductor laser according to claim 12, wherein said buried semiconductor layer has a refractive index not higher than that of an active layer.

22. The manufacturing method of a semiconductor laser according to claim 12, wherein said buried semiconductor layer is made of AlxGa1-xN (0≤x≤1).

23. The manufacturing method of a semiconductor laser according to claim 12, wherein said semiconductor laser is a real index-guided semiconductor laser.

24. A semiconductor device comprising:
a compound semiconductor base body having a projection: and
a buried semiconductor layer made of a compound semiconductor at least a part of which is a non-single crystal, and provided to bury said projection
**characterized in that**
said buried semiconductor layer is at least partly polycrystalline.

25. A semiconductor device according to claim 24, wherein
said base body is made of a nitride III-V compound semiconductor.

26. The semiconductor device according to claim 25, wherein said buried semiconductor layer is made of a nitride III-V compound semiconductor.

27. The semiconductor device according to claim 26, wherein said buried semiconductor layer includes a region of a single crystal and a region of a polycrystal.

28. The semiconductor device according to claim 26, wherein said buried semiconductor layer has a columnar structure.

29. The semiconductor device according to claim 28, wherein diameter of a columnar crystal forming said buried semiconductor layer is in the range from 5 nm to 300 nm.

30. The semiconductor device according to claim 26, wherein said buried semiconductor layer is made of AIxGa1-xN (0≤x≤1).

31. A manufacturing method of a semiconductor device having a base body made of a compound semiconductor and having a projection, and having a buried semiconductor layer made of a compound semiconductor at least a part of which is a non-single crystal so as to bury said projection, comprising the steps of:
forming said projection;
growing a buried semiconductor layer of a compound semiconductor to cover said projection at a growth temperature such that at least a part of said buried semiconductor layer around said projection be a polycrystal; and
removing a part of said buried semiconductor layer from above said projection.

32. A manufacturing method of a semiconductor device according to claim 31, wherein said base body is made of a nitride III-V compound semiconductor.

33. The manufacturing method of a semiconductor device according to claim 32, wherein said buried semiconductor layer is made of a nitride III-V compound semiconductor.

34. The manufacturing method of a semiconductor device according to claim 33, wherein said buried semiconductor layer includes a region of a single crystal and a region of a polycrystal.

35. The manufacturing method of a semiconductor device according to claim 33, wherein said buried semiconductor layer has a columnar structure.

36. The manufacturing method of a semiconductor device according to claim 35 wherein diameter of a columnar crystal forming said buried semiconductor layer is in the range from 5 nm to 300 nm.

37. The manufacturing method of a semiconductor device according to claim 33, wherein said buried semiconductor layer is grown under a growth temperature not lower than the decomposition temperature of a source material for growth thereof and not higher than 760 °C.

38. The manufacturing method of a semiconductor device according to claim 33, wherein said buried semiconductor layer is grown under a growth temperature in the range from 480 °C to 760 °C.

39. The manufacturing method of a semiconductor device according to claim 33, wherein said buried semiconductor layer is grown under a growth temperature in the range from 520 °C to 760 °C.

40. The manufacturing method of a semiconductor device according to claim 33, wherein said buried semiconductor layer is grown by metal organic chemical vapor deposition, hydride vapor phase epitaxial growth or molecular beam epitaxy.

41. The manufacturing method of a semiconductor device according to claim 33, wherein said buried semiconductor layer is grown by electron cyclotron resonance sputtering.

42. The manufacturing method of a semiconductor device according to claim 33, wherein said buried semiconductor layer is made of AlxGa1-xN (0≤x≤1).

## Patentansprüche

1. Halbleiterlaser, der einen Verbindungshalbleiter verwendet und einen stegförmigen Streifen besitzt, mit:
einer vergrabenen Halbleiterlage, die aus einem Verbindungshalbleiter hergestellt ist, von dem zumindest ein Teil kein Einkristall ist und in dem gegenüberliegende Seiten des Stegs vergraben sind,
**dadurch gekennzeichnet, dass**
die vergrabene Halbleiterlage wenigstens teilweise polykristallin ist.

2. Halbleiterlaser nach Anspruch 1, wobei der Halbleiterlaser einen Nitrid-III-V-Verbindungshalbleiter verwendet.

3. Halbleiterlaser nach Anspruch 1 oder 2, bei dem die vergrabene Halbleiterlage aus einem Nitrid-III-V-Verbindungshalbleiter hergestellt ist.

4. Halbleiterlaser nach Anspruch 3, bei dem die vergrabene Halbleiterlage einen Bereich aus einem Einkristall und einen Bereich aus einem Polykristall enthält.

5. Halbleiterlaser nach Anspruch 3, bei dem die vergrabene Halbleiterlage eine säulenartige Struktur hat.

6. Halbleiterlaser nach Anspruch 5, bei dem der Durchmesser eines säulenartigen Kristalls, der die vergrabene Halbleiterlage bildet, im Bereich von 5 nm bis 300 nm liegt.

7. Halbleiterlaser nach Anspruch 3, bei dem die vergrabene Halbleiterlage einen Brechungsindex besitzt, der nicht höher als jener einer aktiven Lage ist.

8. Halbleiterlaser nach Anspruch 3, bei dem die vergrabene Halbleiterlage aus AlₓGa₁₋ₓN (0 ≤ x ≤ 1) hergestellt ist.

9. Halbleiterlaser nach Anspruch 3, wobei der Halbleiterlaser ein Realindex-geführter Halbleiterlaser ist.

10. Verfahren für die Herstellung eines Halbleiterlasers unter Verwendung eines Verbindungshalbleiters, der einen stegförmigen Streifen besitzt, mit den folgenden Schritten:
Bilden des stegförmigen Streifens;
Aufwachsenlassen einer vergrabenen Halbleiterlage aus einem Verbindungshalbleiter für die Abdeckung des Stegs bei einer Wachstumstemperatur, bei der wenigstens ein Teil der vergrabenen Halbleiterlage auf gegenüberliegenden Seiten des Stegs ein Polykristall ist; und
Entfernen eines Teils der vergrabenen Halbleiterlage von der Oberseite des Stegs.

11. Verfahren für die Herstellung eines Halbleiterlasers nach Anspruch 10, bei dem der Halbleiterlaser einen Nitrid-III-V-Verbindungshalbleiter verwendet.

12. Verfahren für die Herstellung eines Halbleiterlasers nach Anspruch 11, bei dem die vergrabene Halbleiterlage aus einem Nitrid-III-V-Verbindungshalbleiter hergestellt ist.

13. Verfahren für die Herstellung eines Halbleiterlasers nach Anspruch 12, bei dem die vergrabene Halbleiterlage einen Bereich aus einem Einkristall und einen Bereich aus einem Polykristall enthält.

14. Verfahren für die Herstellung eines Halbleiterlasers nach Anspruch 12, bei dem die vergrabene Halbleiterlage eine säulenartige Struktur hat.

15. Verfahren für die Herstellung eines Halbleiterlasers nach Anspruch 14, bei dem der Durchmesser eines säulenartigen Kristalls, der die vergrabene Halbleiterlage bildet, im Bereich von 5 nm bis 300 nm liegt.

16. Verfahren für die Herstellung eines Halbleiterlasers nach Anspruch 12, bei dem die vergrabene Halbleiterlage bei einer Wachstumstemperatur aufwächst, die nicht niedriger als die Zerlegungstemperatur eines Ausgangsmaterials für ihr Wachstum und nicht höher als 760 °C ist.

17. Verfahren für die Herstellung eines Halbleiterlasers nach Anspruch 12, bei dem die vergrabene Halbleiterlage bei einer Wachstumstemperatur im Bereich von 480 °C bis 760 °C aufwächst.

18. Verfahren für die Herstellung eines Halbleiterlasers nach Anspruch 12, bei dem die vergrabene Halbleiterlage bei einer Wachstumstemperatur im Bereich von 520 °C bis 760 °C aufwächst.

19. Verfahren für die Herstellung eines Halbleiterlasers nach Anspruch 12, bei dem die vergrabene Halbleiterlage durch eine metallorganische chemische Abscheidung aus der Dampfphase, ein epitaktisches Wachstum in der Hydrid-Dampfphase oder eine Molekularstrahl-Epitaxie aufwächst.

20. Verfahren für die Herstellung eines Halbleiterlasers nach Anspruch 12, bei dem die vergrabene Halbleiterlage durch Elektronen-Zyklotronresonanz-Katodenzerstäubung aufwächst.

21. Verfahren für die Herstellung eines Halbleiterlasers nach Anspruch 12, bei dem die vergrabene Halbleiterlage einen Brechungsindex besitzt, der nicht größer als jener einer aktiven Lage ist.

22. Verfahren für die Herstellung eines Halbleiterlasers nach Anspruch 12, bei dem die vergrabene Halbleiterlage aus AlₓGa₁₋ₓN (0 ≤ x ≤ 1) hergestellt ist.

23. Verfahren für die Herstellung eines Halbleiterlasers nach Anspruch 12, bei dem der Halbleiterlaser ein Realindex-geführter Halbleiterlaser ist.

24. Halbleitervorrichtung, mit:
einem Verbindungshalbleiter-Grundkörper, der einen Schutz besitzt; und
einer vergrabenen Halbleiterlage, die aus einem Verbindungshalbleiter hergestellt ist, von der wenigstens ein Teil kein Einkristall ist und die dazu vorgesehen ist, den Schutz zu vergraben,
**dadurch gekennzeichnet, dass**
die vergrabene Halbleiterlage zumindest teilweise polykristallin ist.

25. Halbleitervorrichtung nach Anspruch 24, bei der
der Grundkörper aus einem Nitrid-III-V-Verbindungshalbleiter hergestellt ist.

26. Halbleitervorrichtung nach Anspruch 25, bei der die vergrabene Halbleiterlage aus einem Nitrid-III-V-Verbindungshalbleiter hergestellt ist.

27. Halbleitervorrichtung nach Anspruch 26, bei der die vergrabene Halbleiterlage einen Bereich aus einem Einkristall und einen Bereich aus einem Polykristall enthält.

28. Halbleitervorrichtung nach Anspruch 26, bei der die vergrabene Halbleiterlage eine säulenartige Struktur hat.

29. Halbleitervorrichtung nach Anspruch 28, bei der der Durchmesser eines säulenartigen Kristalls, der die vergrabene Halbleiterlage bildet, im Bereich von 5 nm bis 30 nm liegt.

30. Halbleitervorrichtung nach Anspruch 26, bei der die vergrabene Halbleiterlage aus AlₓGa₁₋ₓN (0 ≤ x ≤ 1) hergestellt ist.

31. Verfahren für die Herstellung einer Halbleitervorrichtung, die einen aus einem Verbindungshalbleiter hergestellten Grundkörper besitzt, einen Schutz aufweist und eine vergrabene Halbleiterlage besitzt, die aus einem Verbindungshalbleiter hergestellt ist, wovon wenigstens ein Teil kein Einkristall ist, um den Schutz zu vergraben, mit den folgenden Schritten:
Bilden des Schutzes;
Aufwachsenlassen einer vergrabenen Halbleiterlage aus einem Verbindungshalbleiter, um den Schutz abzudecken, bei einer Wachstumstemperatur, bei der zumindest ein Teil der vergrabenen Halbleiterlage um den Schutz ein Polykristall ist; und
Entfernen eines Teils der vergrabenen Halbleiterlage von der Oberseite des Schutzes.

32. Verfahren für die Herstellung einer Halbleitervorrichtung nach Anspruch 31, bei dem der Grundkörper aus einem Nitrid-III-V-Verbindungshalbleiter hergestellt ist.

33. Verfahren für die Herstellung einer Halbleitervorrichtung nach Anspruch 32, bei dem die vergrabene Halbleiterlage aus einem Nitrid-III-V-Verbindungshalbleiter hergestellt ist.

34. Verfahren für die Herstellung einer Halbleitervorrichtung nach Anspruch 33, bei dem die vergrabene Halbleiterlage einen Bereich aus einem Einkristall und einen Bereich aus einem Polykristall enthält.

35. Verfahren für die Herstellung einer Halbleitervorrichtung nach Anspruch 33, bei dem die vergrabene Halbleiterlage eine säulenartige Struktur hat.

36. Verfahren für die Herstellung einer Halbleitervorrichtung nach Anspruch 35, bei der der Durchmesser eines säulenartigen Kristalls, der die vergrabene Halbleiterlage bildet, im Bereich von 5 nm bis 300 nm liegt.

37. Verfahren für die Herstellung einer Halbleitervorrichtung nach Anspruch 33, bei dem die vergrabene Halbleiterlage bei einer Wachstumstemperatur aufwächst, die nicht niedriger als die Zerlegungstemperatur eines Ausgangsmaterials für das Wachstum und nicht höher als 760 °C ist.

38. Verfahren für die Herstellung einer Halbleitervorrichtung nach Anspruch 33, bei dem die vergrabene Halbleiterlage bei einer Wachstumstemperatur im Bereich von 480 °C bis 760 °C aufwächst.

39. Verfahren für die Herstellung einer Halbleitervorrichtung nach Anspruch 33, bei der die vergrabene Halbleiterlage bei einer Wachstumstemperatur im Bereich von 520 °C bis 760 °C aufwächst.

40. Verfahren für die Herstellung einer Halbleitervorrichtung nach Anspruch 33, bei der die vergrabene Halbleiterlage durch eine metallorganische chemische Abscheidung aus der Dampfphase, ein epitaktisches Wachstum in der Hydrid-Dampfphase oder eine Molekularstrahl-Epitaxie aufwächst.

41. Verfahren für die Herstellung einer Halbleitervorrichtung nach Anspruch 33, bei dem die vergrabene Halbleiterlage durch Elektronen-Zyklotronresonanz-Katodenzerstäubung aufwächst.

42. Verfahren für die Herstellung einer Halbleitervorrichtung nach Anspruch 33, bei dem die vergrabene Halbleiterlage aus AlₓGa₁₋ₓN (0 ≤ x ≤ 1) hergestellt ist.

## Revendications

1. Laser à semiconducteur utilisant un semiconducteur composé et possédant une bande en forme d'arête, comportant :
une couche semiconductrice enterrée constituée d'un semiconducteur composé, dont au moins une partie n'est pas un monocristal, et enterrant des côtés opposés de l'arête,
**caractérisé en ce que** ladite couche semiconductrice enterrée est au moins en partie polycristalline.

2. Laser à semiconducteur selon la revendication 1, dans lequel ledit laser à semiconducteur utilise un semiconducteur composé de nitrure III-V.

3. Laser à semiconducteur selon la revendication 1 ou 2, dans lequel ladite couche semiconductrice enterrée est constituée d'un semiconducteur composé de nitrure III-V.

4. Laser à semiconducteur selon la revendication 3, dans lequel ladite couche semiconductrice enterrée comprend une région monocristalline et une région polycristalline.

5. Laser à semiconducteur selon la revendication 3, dans lequel ladite couche semiconductrice enterrée présente une structure en colonne.

6. Laser à semiconducteur selon la revendication 5, dans lequel le diamètre d'un cristal en colonne formant ladite couche semiconductrice enterrée est de l'ordre de 5 nm à 300 nm.

7. Laser à semiconducteur selon la revendication 3, dans lequel ladite couche semiconductrice enterrée possède un indice de réfraction non supérieur à celui d'une couche active.

8. Laser à semiconducteur selon la revendication 3, dans lequel ladite couche semiconductrice enterrée est constituée de AlxGa1-xN (0≤ x ≤ 1).

9. Laser à semiconducteur selon la revendication 3, dans lequel ledit laser à semiconducteur est un laser à semiconducteur guidé par l'indice réel.

10. Procédé de fabrication d'un laser à semiconducteur utilisant un semiconducteur composé et possédant une bande en forme d'arête, comportant les étapes consistant à :
former ladite bande en forme d'arête ;
faire croître une couche semiconductrice enterrée d'un semiconducteur composé pour recouvrir l'arête à une température de croissance telle qu'au moins une partie de ladite couche semiconductrice enterrée aux côtés opposés est polycristalline ; et
enlever une partie de ladite couche semiconductrice enterrée depuis le dessus de ladite arête.

11. Procédé de fabrication d'un laser à semiconducteur selon la revendication 10, dans lequel ledit laser à semiconducteur utilise un semiconducteur composé de nitrure III-V.

12. Procédé de fabrication d'un laser à semiconducteur selon la revendication 11, dans lequel ladite couche semiconductrice enterrée est constituée d'un semiconducteur composé de nitrure III-V.

13. Procédé de fabrication d'un laser à semiconducteur selon la revendication 12, dans lequel ladite couche semiconductrice enterrée comprend une région monocristalline et une région polycristalline.

14. Procédé de fabrication d'un laser à semiconducteur selon la revendication 12, dans lequel ladite couche semiconductrice enterrée possède une structure en colonne.

15. Procédé de fabrication d'un laser à semiconducteur selon la revendication 14, dans lequel le diamètre d'un cristal en colonne formant ladite couche semiconductrice enterrée est de l'ordre de 5 nm à 300 nm.

16. Procédé de fabrication d'un laser à semiconducteur selon la revendication 12, dans lequel ladite couche semiconductrice enterrée est faite croître sous une température de croissance non inférieure à la température de décomposition d'un matériau source pour la croissance et non supérieure à 760°C.

17. Procédé de fabrication d'un laser à semiconducteur selon la revendication 12, dans lequel ladite couche semiconductrice enterrée est faite croître sous une température de croissance de l'ordre de 480°C à 760°C.

18. Procédé de fabrication d'un laser à semiconducteur selon la revendication 12, dans lequel ladite couche semiconductrice enterrée est faite croître sous une température de croissance de l'ordre de 520°C à 760°C.

19. Procédé de fabrication d'un laser à semiconducteur selon la revendication 12, dans lequel ladite couche semiconductrice enterrée est faite croître par dépôt chimique en phase vapeur organométallique, croissance épitaxiale en phase vapeur hybride ou épitaxie par faisceau moléculaire.

20. Procédé de fabrication d'un laser à semiconducteur selon la revendication 12, dans lequel ladite couche semiconductrice enterrée est faite croître par pulvérisation à résonance électronique cyclotronique.

21. Procédé de fabrication d'un laser à semiconducteur selon la revendication 12, dans lequel ladite couche semiconductrice enterrée possède un indice de réfraction non supérieur à celui d'une couche active.

22. Procédé de fabrication d'un laser à semiconducteur selon la revendication 12, dans lequel ladite couche semiconductrice enterrée est constituée de Alx-Gal-xN (0 ≤ x ≤ 1).

23. Procédé de fabrication d'un laser à semiconducteur selon la revendication 12 dans lequel ledit laser à semiconducteur est un laser à semiconducteur guidé par l'indice réel.

24. Dispositif à semiconducteur comportant :
un corps de base à semiconducteur composé possédant une partie saillante ; et
une couche semiconductrice enterrée constituée d'un semiconducteur composé dont au moins une partie n'est pas un monocristal et prévue pour enterrer ladite partie saillante,
**caractérisé en ce que** ladite couche semiconductrice enterrée est au moins en partie polycristalline.

25. Dispositif à semiconducteur selon la revendication 24, dans lequel ledit corps de base est constitué d'un semiconducteur composé de nitrure III-V.

26. Dispositif à semiconducteur selon la revendication 25, dans lequel ladite couche semiconductrice enterrée est constituée d'un semiconducteur composé de nitrure III-V.

27. Dispositif à semiconducteur selon la revendication 26, dans lequel ladite couche semiconductrice enterrée comprend une région monocristalline et une région polycristalline.

28. Dispositif à semiconducteur selon la revendication 26, dans lequel ladite couche semiconductrice enterrée possède une structure en colonne.

29. Dispositif à semiconducteur selon la revendication 28, dans lequel le diamètre d'un cristal en colonne formant ladite couche semiconductrice enterrée est compris entre 5 nm et 300 nm.

30. Dispositif à semiconducteur selon la revendication 26, dans lequel ladite couche semiconductrice est constituée de AlxGa1-xN (0 ≤ x ≤ 1).

31. Procédé de fabrication d'un dispositif à semiconducteur possédant un corps de base constitué d'un semiconducteur composé et présentant une partie saillante, et possédant une couche semiconductrice enterrée constituée d'un semiconducteur composé dont au moins une partie n'est pas monocristalline de manière à enterrer ladite partie saillante, comprenant les étapes consistant à :
former ladite partie saillante ;
faire croître une couche semiconductrice enterrée d'un semiconducteur composé pour recouvrir ladite partie saillante à une température de croissance telle qu'au moins une partie de ladite couche semiconductrice enterrée autour de ladite partie saillante est polycristalline ; et
enlever une partie de la couche semiconductrice enterrée depuis le dessus de ladite partie saillante.

32. Procédé de fabrication d'un dispositif à semiconducteur selon la revendication 31, dans lequel ledit corps de base est constitué d'un semiconducteur composé de nitrure III-V.

33. Procédé de fabrication d'un dispositif à semiconducteur selon la revendication 32, dans lequel ladite couche semiconductrice enterrée est constituée de semiconducteur composé à nitrure III-V.

34. Procédé de fabrication d'un dispositif à semiconducteur selon la revendication 33, dans lequel ladite couche semiconductrice enterrée comprend une région monocristalline et une région polycristalline.

35. Procédé de fabrication d'un dispositif à semiconducteur selon la revendication 33, dans lequel ladite couche semiconductrice enterrée possède une structure en colonne.

36. Procédé de fabrication d'un dispositif à semiconducteur selon la revendication 35, dans lequel le diamètre d'un cristal en colonne formant ladite couche semiconductrice enterrée est compris entre 5 nm et 300 nm.

37. Procédé de fabrication d'un dispositif à semiconducteur selon la revendication 33, dans lequel ladite couche semiconductrice enterrée est faite croître sous une température de croissance non inférieure à la température de décomposition d'un matériau source pour la croissance et non supérieure à 760°C.

38. Procédé de fabrication d'un dispositif à semiconducteur selon la revendication 33, dans lequel ladite couche semiconductrice enterrée est faite croître sous une température de croissance de l'ordre de 480°C à 760°C.

39. Procédé de fabrication d'un dispositif à semiconducteur selon la revendication 33, dans lequel ladite couche semiconductrice enterrée est faite croître sous une température de croissance de l'ordre de 520°C à 760°C.

40. Procédé de fabrication d'un dispositif à semiconducteur selon la revendication 33, dans lequel ladite couche semiconductrice enterrée est faite croître par dépôt chimique en phase vapeur organométallique, croissance épitaxiale en phase vapeur hybride ou épitaxie par faisceau moléculaire.

41. Procédé de fabrication d'un dispositif à semiconducteur selon la revendication 33, dans lequel ladite couche semiconductrice enterrée est faite croître par pulvérisation par résonance électronique cyclotronique.

42. Procédé de fabrication d'un dispositif à semiconducteur selon la revendication 33, dans lequel ladite couche semiconductrice enterrée est constituée de AlxGa1-xN (0 ≤ x ≤ 1).
